# EUROPÄISCHE PATENTSCHRIFT

(11) **EP 4 032 866 B1**
(45) Veröffentlichungstag und Bekanntmachung des Hinweises auf die Patenterteilung: **19.11.2025**
(21) Anmeldenummer: 21152527.4
(22) Anmeldetag: 20.01.2021
(51) Int. Cl.: C03C 17/00, C03C 17/06, C03C 17/28, C03C 17/32, F24C 15/00

(54) **MAGNETISCHE HAFTUNG AM HAUSHALTSGERÄT**
MAGNETIC ADHESION TO A HOUSEHOLD APPLIANCE
ADHÉSION MAGNÉTIQUE À L'APPAREIL ÉLECTROMÉNAGER

(43) Veröffentlichungstag der Anmeldung: 27.07.2022
(73) Patentinhaber: V-Zug AG, 6300 Zug (CH)
(72) Erfinder: Hürlimann, Kilian, 8037 Zürich (CH)
(74) Vertreter: E. Blum & Co. AG

(56) Entgegenhaltungen:
- WO-A1-2017/168443
- WO-A1-2020/025526

## Beschreibung

### Gebiet der Erfindung

Die Erfindung betrifft ein Gerät aus der Gruppe Backofen, Mikrowelle, Dampfgargerät, Kühlschrank, Weinkühlschrank oder Tiefgefriergerät mit einem Gerätegehäuse. Das Gerätegehäuse besteht zumindest teilweise aus einem Glas. Das Glas weist eine Glasaussenoberfläche und eine Glasinnenoberfläche auf.

### Hintergrund

Es besteht das Bedürfnis, in einer Küche Notizzettel, insbesondere Einkaufslisten oder Rezepte, aufzuhängen. Notizzettel können beispielsweise Klebezettel sein oder sie können mittels eines Permanentmagneten an einer magnetisierbaren Oberfläche magnetisch angeheftet werden.

Klebezettel haben den Vorteil, dass sie an fast allen Oberflächen angeordnet werden können. Nachteilig ist, dass der Klebstoff an den Oberflächen Rückstände hinterlässt. Im Gegensatz dazu hinterlassen Permanentmagnete keine Rückstände. Sie können allerdings nur an magnetisierbaren Oberflächen angeheftet werden.

WO 2020/025526 zeigt ein Induktionskochfeld, bei welchem die Wärme nicht im Kochtopf, sondern auf einer Platte des Kochfeldes induziert wird. Wärme wird von der Platte zum Kochtopf mittels Wärmeleitung transferiert.

### Darstellung der Erfindung

Es stellt sich deshalb die Aufgabe, die Möglichkeiten, Notizzettel an Haushaltsgeräten anzuheften, zu erweitern.

Diese Aufgabe wird durch den Gegenstand des unabhängigen Anspruchs gelöst. Demgemäss umfasst ein Gerät aus der Gruppe Backofen, Mikrowelle, Dampfgargerät, Kühlschrank, Weinkühlschrank oder Tiefgefriergerät ein Gerätegehäuse. Ein Gerätegehäuse ist eine Umhüllung des Gerätes.

Das Gerätegehäuse besteht zumindest teilweise aus Glas. Das Glas weist eine Glasaussenoberfläche und eine Glasinnenoberfläche auf. "Innen" und "Aussen" sind in Relation zum Gerät zu verstehen. Die Aussenoberfläche ist zur Aussenseite des Gerätes gerichtet, d.h. die Glasaussenoberfläche ist für den Benutzer von aussen zugänglich. Die Innenoberfläche ist zur Innenseite des Gerätes gerichtet.

Bevorzugt handelt es sich beim Glas um eine Glasplatte mit einer ebenen Glasaussenoberfläche und einer ebenen Glasinnenoberfläche.

Das Gerätegehäuse ist derart ausgestaltet, dass ein Permanentmagnet an der Glasaussenoberfläche magnetisch haftet.

Dies hat den Vorteil, dass Haushaltsgeräte, dessen Gerätegehäuse, insbesondere die Frontseite, aus Glas besteht, eine Fläche bieten, an welcher Notizzettel magnetisch angeheftet werden können. Damit stehen in einer Küche zusätzliche Flächen zur Verfügung, auf welchen Notizzettel sinnvoll und gut sichtbar mittels eines Permanentmagneten angeheftet werden können.

Die Glasaussenoberfläche ist die Oberfläche des Glases selbst. D.h. der Notizzettel wird direkt auf das Glas befestigt. Zwischen Notizzettel und Glas ist keine weitere Schicht notwendig, damit die magnetische Haftung gewährleistet ist.

Gerätegehäuseinnenseitig ist am Glas eine Beschichtung angeordnet, welche aus einem magnetisierbaren Material besteht. Die magnetisierbare Beschichtung hat den Vorteil, dass an der Glasaussenoberfläche ein Permanentmagnet magnetisch haftet.

Gerätegehäuseinnenseitig bedeutet, dass die Beschichtung auf der Innenseite des Glases angeordnet ist. Die Beschichtung muss aber nicht zwingend direkt an der Glasinnenoberfläche angeordnet sein. Bevorzugt ist die Beschichtung aber direkt an der Glasinnenoberfläche angeordnet. Ist die Beschichtung nicht direkt an der Glasinnenoberfläche angeordnet, kann zwischen Beschichtung und Glas beispielsweise eine nicht magnetisierbare Schicht, insbesondere eine nicht magnetisierbare Farbschicht, angeordnet sein.

Insbesondere handelt es sich bei der Beschichtung um eine Magnetfarbe. Diese kann auf die Glasinnenoberfläche aufgedruckt werden. Dies erlaubt ein einfaches Aufbringen der Beschichtung auf das Glas.

In einer bevorzugten Ausführungsform weist die Beschichtung eine Matrix auf Epoxid- oder Acrylbasis auf. Insbesondere ist die Matrix thermostabil bis zu einer Temperatur von 200°C, insbesondere 250°C. Diese Thermostabilität ist beispielsweise durch den Fachmann bekannte Epoxidharze gewährleistet. Dies ermöglicht, dass die Beschichtung auch an Orten aufgetragen werden kann, bei welchen während des Betriebs des Gerätes hohe Temperaturen herrschen, beispielsweise bei einem Backofen.

Bevorzugt umfasst die Beschichtung Eisenpigmente, d.h. insbesondere die Matrix auf Epoxid- oder Acrylbasis schliesst die Eisenpigmente ein. Dadurch wird die Beschichtung magnetisierbar. Insbesondere ist die Beschichtung ferromagnetisch.

Mit Vorteil weist die Beschichtung eine Dicke von mindestens 0.3 mm, insbesondere mindestens 0.5 mm, insbesondere mindestens 0.8 mm, insbesondere mindestens 1.0 mm, auf. Je dicker die Schicht aufgetragen wird, umso stärker haftet ein Permanentmagnet an der Glasaussenoberfläche.

Insbesondere weist die Beschichtung die Form eines Rahmens auf. Dieser Rahmen soll eine transparente Glasfläche umrahmen. Eine solche Ausgestaltung ist beispielsweise bei einer Backofentüre von Vorteil. Die Backofentüre weist einen mit der Magnetfarbe gefärbten Rahmen auf, welcher optisch gut wirkt und an welchem Permanentmagnete haften. Gleichzeitig umschliesst der Rahmen einen Bereich des Glases, auf welchem keine Farbe aufgetragen ist. Dieser Bereich ist somit transparent und der Benutzer kann von aussen durch diesen transparenten Bereich in das Innere des Backofens sehen.

Ist die Beschichtung, wie erwähnt, auf der Glasinnenoberfläche einer Gerätetüre angeordnet, so kann es sich dabei um das äussere Glas einer doppelverglasten Gerätetüre handeln. Damit ist die Beschichtung vor den im Backofen herrschenden hohen Temperaturen geschützt.

Wie erwähnt kann die Beschichtung an der Gerätetüre angeordnet sein. Alternativ können auch andere Bestandteile des Gerätegehäuses aus Glas ausgestaltet sein, z.B. die Bedienblende, an welcher Permanentmagnete haften können.

Insbesondere bei Weinkühlschränken ist es bevorzugt, die Türe aus Glas auszugestalten, damit der Benutzer von aussen in das Innere des Weinkühlschrankes schauen kann.

### Kurze Beschreibung der Zeichnungen

Weitere Ausgestaltungen, Vorteile und Anwendungen der Erfindung ergeben sich aus den abhängigen Ansprüchen und aus der nun folgenden Beschreibung anhand der Figuren. Dabei zeigen:
Fig. 1 ein Gargerät mit einer Gerätetüre;
Fig. 2a die Frontseite der Gerätetüre mit Blick von aussen;
Fig. 2b die Innenseite der äusseren Glasscheibe der Gerätetüre;
Fig. 3a eine Schnittansicht eines vorderen Abschnittes eines Backofens mit geschlossener Türe; und
Fig. 3b den Backofen aus Fig. 3a mit geöffneter Türe.

### Weg zur Ausführung der Erfindung

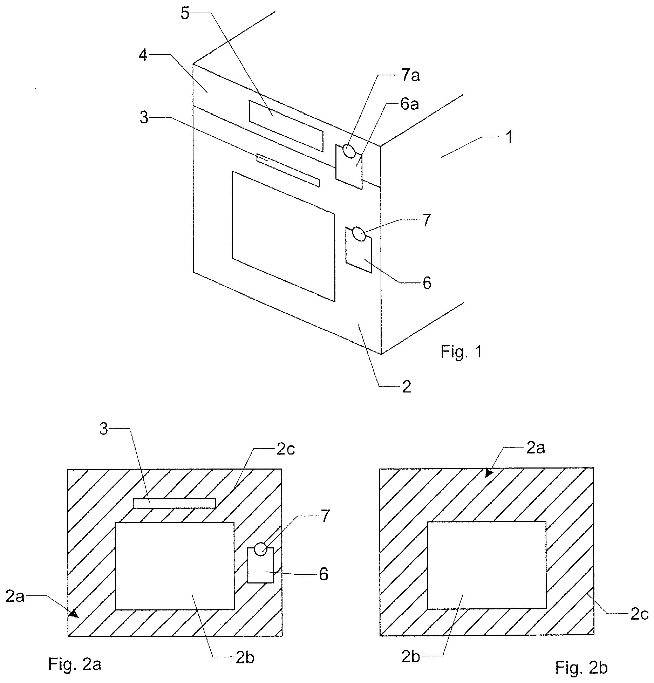

Fig. 1 zeigt einen Backofen mit einem Gerätegehäuse 1. Alternativ könnte es auch eine Mikrowelle, ein Dampfgargerät oder ein anderes Haushaltsgerät sein. Der Backofen umfasst eine Gerätetüre 2, welche Bestandteil des Gerätegehäuses 1 ist. An der Gerätetüre 2 ist ein Türgriff 3 angeordnet. Durch Öffnen und Schliessen der Gerätetüre erhält der Benutzer Zugang zum Garraum des Backofens. Oberhalb der Gerätetüre 2 befindet sich eine Blende 4 mit einer Bedienanzeige 5. Die Bedienanzeige 5 ist eine berührungsempfindliche Bedienanzeige, d.h. der Benutzer kann durch Berührungen der Bedienanzeige 5 den Backofen steuern. Sowohl die Gerätetüre 2 als auch die Blende 4 sind an der Frontseite aus Glas ausgestaltet.

An der Frontseite der Gerätetüre 2 ist ein Notizzettel 6 mittels eines Permanentmagneten 7 angeheftet. Es wird nun näher beschrieben, wie die Gerätetüre 2 ausgestaltet sein muss, damit der Permanentmagnet 7 an der Frontseite der Gerätetüre 2 magnetisch haftet.

Im Weiteren ist auch ein zweiter Notizzettel 6a mittels eines zweiten Notizzettels 7a an der Frontseite der Blende 4 angeordnet.

Die Fig. 2a zeigt die Gerätetüre 2 mit Frontansicht von aussen. An ihrer Aussenseite weist die Gerätetüre 2 eine Glasplatte 2a auf. Diese Glasplatte 2a erstreckt sich über die gesamte in Fig. 2a gezeigte Fläche, d.h. sowohl über die schraffierte als auch über die weisse eingerahmte Fläche. Sie wird lediglich vom Türgriff 3, dem Notizzettel 6 und dem Permanentmagneten 7 überdeckt. Im mittleren Bereich 2b ist die Gerätetüre 2 transparent, d.h. der Benutzer kann durch den mittleren Bereich 2b in den Garraum hineinschauen. Umrahmt wird die mittlere Fläche 2b von einer schwarz umrahmten Fläche 2c. Diese Fläche ist schraffiert dargestellt. Die Fläche 2c erscheint schwarz, weil auf der Rückseite der Glasplatte 2a der Bereich 2c mit einer dunklen Farbe beschichtet ist. Die Rückseite der Glasplatte 2a ist in Fig. 2b gezeigt.

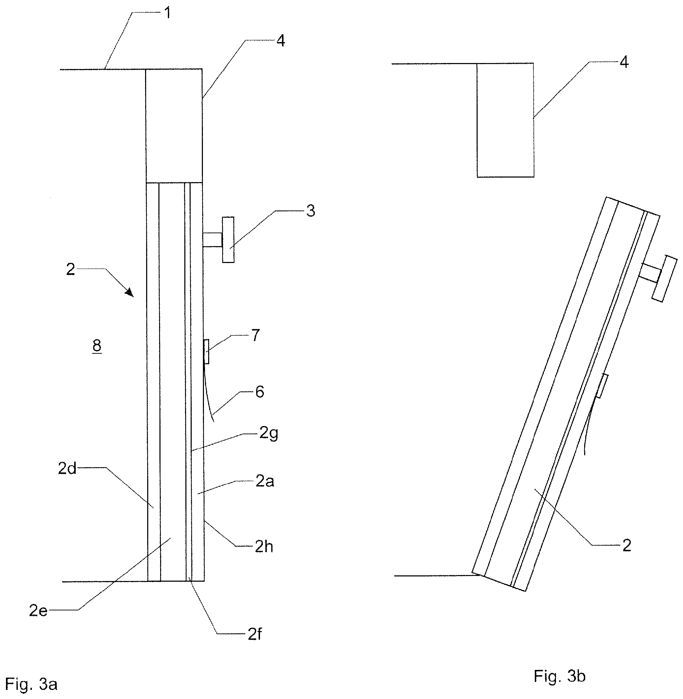

Die Fig. 3a und 3b zeigen eine Schnittansicht durch den Backofen. Sichtbar sind die Gerätetüre 2 und die Blende 4. An der Frontseite ist zudem der Türgriff 3 sichtbar. Die Gerätetüre 2 weist eine zweifach-Verglasung auf. Gegen aussen ist an der Gerätetüre die Glasplatte 2a angeordnet, welche beispielsweise ein Floatglas oder ein normales Flachglas ist. Zum Inneren des Backofens ist eine zweite Glasplatte 2d angeordnet. Diese grenzt an den Garraum 8. Zwischen der Glasplatte 2a und der zweiten Glasplatte 2d ist der Glaszwischenraum 2e. Dieser Glaszwischenraum 2e ist luftdicht abgeschlossen und sorgt für eine gute thermische Isolierung. Ebenfalls sichtbar ist der an der Frontseite mit dem Permanentmagneten 7 angeheftete Notizzettel 6.

Die äussere Glasplatte 2a weist eine Glasinnenoberfläche 2g und ein Glasaussenoberfläche 2h auf. An der Glasinnenoberfläche 2g ist eine Beschichtung 2f angeordnet. Diese Beschichtung 2f besteht aus einem magnetisierbaren Material. Es handelt sich um eine Magnetfarbe, welche in einem Druckprozess direkt auf die Glasinnenoberfläche 2g der äusseren Glasplatte 2a aufgedruckt wurde. Die Beschichtung weist eine Dicke von beispielhaft 1 mm auf.

Die Magnetfarbe dieses Ausführungsbeispiels weist eine Acryldispersion auf, welche mit Eisenpigmenten versetzt ist. Nähert sich ein Permanentmagnet von aussen zur Glasplatte 2a, wird die Beschichtung 2f magnetisiert und der Permanentmagnet bleibt an der Glasaussenoberfläche 2h der Glasplatte 2a magnetisch haften. Durch Variation der Dicke der Beschichtung 2f und der Dicke der Glasplatte 2a kann die Anziehungskraft des Permanentmagneten 7 an der Frontseite der Glasplatte 2a eingestellt werden.

Während in der vorliegenden Anmeldung bevorzugte Ausführungen der Erfindung beschrieben sind, ist klar darauf hinzuweisen, dass die Erfindung nicht auf diese beschränkt ist und in auch anderer Weise innerhalb des Umfangs der folgenden Ansprüche ausgeführt werden kann.

## Patentansprüche

1. Haushaltsgerät aus der Gruppe Backofen, Mikrowelle, Dampfgargerät, Kühlschrank, Weinkühlschrank oder Tiefgefriergerät, mit einem Gerätegehäuse (1), wobei das Gerätegehäuse (1) zumindest teilweise aus Glas (2a) besteht und das Glas (2a) eine Glasaussenoberfläche (2h) und eine Glasinnenoberfläche (2g) aufweist,
**dadurch gekennzeichnet, dass** das Gerätegehäuse (1) derart ausgestaltet ist, dass ein Permanentmagnet (7) an der Glasaussenoberfläche (2h) magnetisch haftet,, wobei gerätegehäuseinnenseitig am Glas (2a) eine Beschichtung (2f) angeordnet ist, welche aus einem magnetisierbaren Material besteht.

2. Haushaltsgerät nach Anspruch 1, wobei die Beschichtung (2f) eine Magnetfarbe ist.

3. Haushaltsgerät nach einem der vorangehenden Ansprüche, wobei die Beschichtung (2f) eine Matrix auf Epoxid- oder Acrylbasis aufweist.

4. Haushaltsgerät nach Anspruch 3, wobei die Matrix thermostabil bis zu einer Temperatur von 200°C, insbesondere 250°C ist.

5. Haushaltsgerät nach einem der vorangehenden Ansprüche, wobei die Beschichtung (2f) Eisenpigmente aufweist.

6. Haushaltsgerät nach einem der vorangehenden Ansprüche, wobei die Beschichtung (2f) ferromagnetisch ist.

7. Haushaltsgerät nach einem der vorangehenden Ansprüche, wobei die Beschichtung (2f) direkt an der Glasinnenoberfläche (2g) angeordnet ist.

8. Haushaltsgerät nach einem der Ansprüche 1 bis 6, wobei zwischen dem Glas (2a) und der Beschichtung (2f) eine nicht magnetisierbare Schicht, insbesondere eine nicht magnetisierbare Farbschicht angeordnet ist.

9. Haushaltsgerät nach einem der vorangehenden Ansprüche, wobei die Beschichtung (2f) eine Dicke von mindestens 0.3 mm, insbesondere mindestens 0.5 mm, insbesondere mindestens 0.8 mm, insbesondere mindestens 1.0 mm, aufweist.

10. Haushaltsgerät nach einem der vorangehenden Ansprüche, wobei die Beschichtung (2f) die Form eines Rahmens (2c) aufweist und eine transparente Glasfläche (2b) umrahmt.

11. Haushaltsgerät nach einem der vorhandenen Ansprüche, wobei das Glas (2a) Bestandteil einer Gerätetüre (2) ist, insbesondere wobei das Glas (2a) ein äusseres Glas (2a) einer zweifach verglasten Gerätetüre (2) ist.

## Claims

1. Household appliance from the group consisting of an oven, microwave, steam cooking appliance, refrigerator, wine refrigerator or freezer, with an appliance housing (1), wherein the appliance housing (1) consists at least partially of glass (2a) and the glass (2a) has a glass outer surface (2h) and a glass inner surface (2g),
**characterised in that** the appliance housing (1) is adapted in such a way that a permanent magnet (7) adheres magnetically to the outer glass surface (2h), wherein a coating (2f) consisting of a magnetisable material is arranged on the inside of the appliance housing on the glass (2a).

2. Household appliance according to claim 1, wherein the coating (2f) is a magnetic paint.

3. Household appliance according to one of the preceding claims, wherein the coating (2f) has an epoxy- or acrylic-based matrix.

4. Household appliance according to claim 3, wherein the matrix is thermostable up to a temperature of 200°C, in particular 250°C.

5. Household appliance according to one of the preceding claims, wherein the coating (2f) comprises iron pigments.

6. Household appliance according to one of the preceding claims, wherein the coating (2f) is ferromagnetic.

7. Household appliance according to one of the preceding claims, wherein the coating (2f) is arranged directly on the inner glass surface (2g).

8. Household appliance according to any one of claims 1 to 6, wherein a non-magnetisable layer, in particular a non-magnetisable paint layer, is arranged between the glass (2a) and the coating (2f).

9. Household appliance according to one of the preceding claims, wherein the coating (2f) has a thickness of at least 0.3 mm, in particular at least 0.5 mm, in particular at least 0.8 mm, in particular at least 1.0 mm.

10. Household appliance according to one of the preceding claims, wherein the coating (2f) has the shape of a frame (2c) and frames a transparent glass surface (2b).

11. Household appliance according to one of the preceding claims, wherein the glass (2a) is a component of an appliance door (2), in particular wherein the glass (2a) is an outer glass (2a) of a double-glazed appliance door (2).

## Revendications

1. Appareil ménager appartenant au groupe des fours, micro-ondes, cuiseurs à vapeur, réfrigérateurs, caves à vin ou congélateurs, avec un boîtier d'appareil (1), dans lequel le boîtier d'appareil (1) est constitué au moins en partie de verre (2a) et le verre (2a) présentant une surface extérieure en verre (2h) et une surface intérieure en verre (2g),
**caractérisé en ce que** le boîtier d'appareil (1) est conçu de telle sorte qu'un aimant permanent (7) adhère magnétiquement à la surface extérieure en verre (2h), dans lequel un revêtement (2f) constitué d'un matériau magnétisable est disposé sur le verre (2a)à l'intérieur du boîtier d'appareil.

2. Appareil ménager selon la revendication 1, dans lequel le revêtement (2f) est une peinture magnétique.

3. Appareil ménager selon l'une des revendications précédentes, dans lequel le revêtement (2f) comporte une matrice à base d'époxy ou d'acrylique.

4. Appareil ménager selon la revendication 3, dans lequel la matrice est thermostable jusqu'à une température de 200°C, en particulier 250°C.

5. Appareil ménager selon l'une des revendications précédentes, dans lequel le revêtement (2f) comporte des pigments de fer.

6. Appareil ménager selon l'une des revendications précédentes, dans lequel le revêtement (2f) est ferromagnétique.

7. Appareil ménager selon l'une des revendications précédentes, dans lequel le revêtement (2f) est disposé directement sur la surface intérieure en verre (2g).

8. Appareil ménager selon l'une des revendications 1 à 6, dans lequel une couche non magnétisable, en particulier une couche de couleur non magnétisable, est disposée entre le verre (2a) et le revêtement (2f).

9. Appareil ménager selon l'une des revendications précédentes, dans lequel le revêtement (2f) a une épaisseur d'au moins 0,3 mm, en particulier d'au moins 0,5 mm, en particulier d'au moins 0,8 mm, en particulier d'au moins 1,0 mm.

10. Appareil ménager selon l'une des revendications précédentes, dans lequel le revêtement (2f) a la forme d'un cadre (2c) et encadre une surface en verre transparente (2b).

11. Appareil ménager selon l'une des revendications précédentes, dans lequel le verre (2a) fait partie intégrante d'une porte d'appareil (2), en particulier dans lequel le verre (2a) est un verre extérieur (2a) d'une porte d'appareil à double vitrage (2).
